(19) Europäisches Patentamt

European Patent Office

Office européen des brevets

(11) **EP 0 900 481 B1**

(12) **EUROPEAN PATENT SPECIFICATION**

(45) Date of publication and mention
of the grant of the patent:
**14.06.2006 Bulletin 2006/24**

(51) Int Cl.:
***H03L 7/08*** (2006.01)

(21) Application number: **98903224.8**

(22) Date of filing: **27.02.1998**

(86) International application number:
**PCT/IB1998/000238**

(87) International publication number:
**WO 1998/040968 (17.09.1998 Gazette 1998/37)**

(54) **A FREQUENCY CONVERSION CIRCUIT**

FREQUENZUMSETZUNGSSCHALTUNG

CIRCUIT DE CONVERSION DE FREQUENCES

(84) Designated Contracting States:
**DE FR GB**

(30) Priority: **12.03.1997 EP 97200739**

(43) Date of publication of application:
**10.03.1999 Bulletin 1999/10**

(73) Proprietor: **Koninklijke Philips Electronics N.V.
5621 BA Eindhoven (NL)**

(72) Inventor: **BALTUS, Petrus, Gerardus
NL-5656 AA Eindhoven (NL)**

(74) Representative: **Deguelle, Wilhelmus H. G.
Philips
Intellectual Property & Standards
P.O. Box 220
5600 AE Eindhoven (NL)**

(56) References cited:
**DE-A- 3 726 181          JP-A- 63 175 507**

• **PATENT ABSTRACTS OF JAPAN; & JP,A,63 175 507 (TOSHIBA CORP) 19 July 1988.**

# Description

The present invention relates to a frequency-conversion circuit with a multistage frequency-converting means, to a telecommunications system, a receiver, a transmitter, a transceiver, an integrated circuit, and a telephone device provided with such a frequency-conversion circuit.

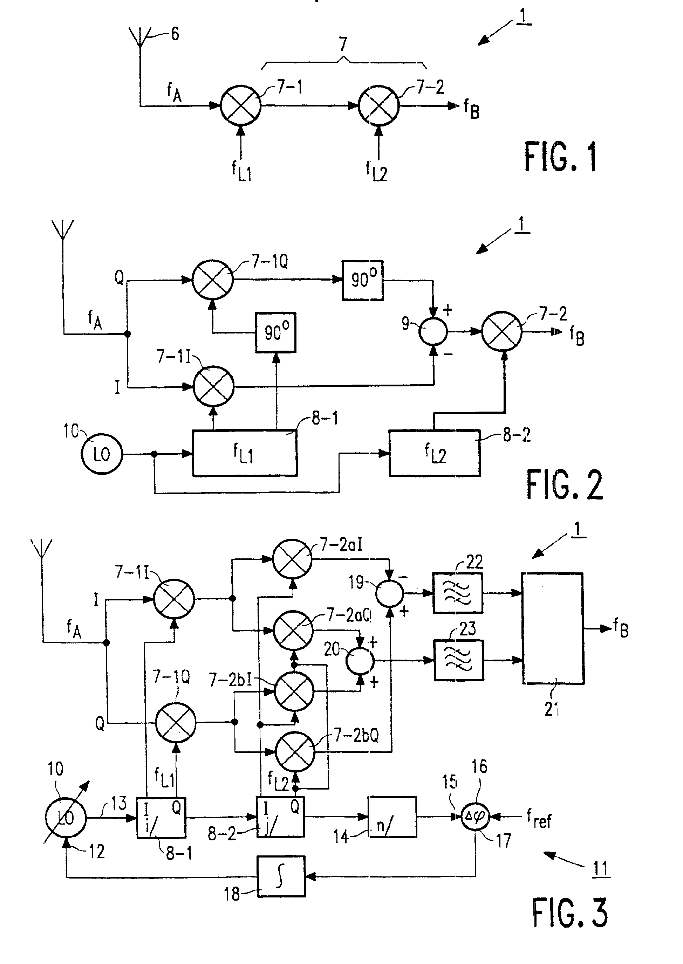

Such a frequency-conversion circuit is known from "High Integration CMOS RF Transceivers", Proc. of the Workshop on Advances in Analog Circuit Design, April 2-3-4, 1996, Lausanne-Ouchy, Switzerland, by F. Brianti et al., 14 pages. This article describes in particular integrated digital radio architectures having a frequency up or down converting means usable, for example, in low-IF, such as zero-IF, or wideband-IF configurations. By definition, a low-IF configuration, such as a receiver, transmitter or transceiver, is a configuration, wherein the intermediate frequency (IF) is close to zero, or zero in case of a zero-IF. Some known advantages of zero-IF configurations are the high degree of integration on a chip that can be achieved as compared to a heterodyne or conventional IF configuration, because of the possibility to apply filters, such as low-pass filters for channel selectivity, than can be integrated at low cost. Reduced power dissipation, fewer interference problems and better crosstalk control than in a conventional configuration that requires external components can be achieved with a careful design of using this zero-IF architecture. The frequency conversion is implemented by means of two stages of mixers (see figure 2) resulting in a multistage frequency conversion in order to reduce the requirements imposed upon image rejection filters in front of the mixers as compared to conventional architectures. The mixer stages are quadrature mixers stages each having an I-path and a Q-path in order to properly distinguish between positive and negative frequencies, corresponding to upper and lower sidebands of an input RF signal. These quadrature mixers eliminate an off-chip IF filter function. Each of the two stages is being fed by a separate voltage-controlled oscillator (VCO) phase-locked loop (PLL) synthesizer circuit. Both synthesizer circuits are connected to a common crystal oscillator. The problem of the known frequency conversion circuit is that two synthesizer circuits are needed, which circuits lead to significant costs and require a large surface area and much power.

JP-A-63175507 discloses a microwave frequency converting circuit which has two oscillator inputs both coupled to an oscillator output. A frequency multiplier is present between the oscillator output and one of the oscillator inputs. Such a sliding IF topology wherein both the local oscillator signals are sliding together (with a fixed frequency ratio) to perform the channel selection is well known.

A two-stage frequency conversion circuit is also shown in DE-A-3 726 181.

It is an object of the present invention to reduce the chip area and power consumption needed for the integrated architectures.

A first aspect of the invention provides a frequency-conversion circuit with a multistage frequency converting means as claimed in claim 1. A second aspect of the invention provides a receiver as claimed in claim 3. A third aspect of the invention provides a transmitter as claimed in claim 5 A fourth aspect of the invention provides a telecommunications system as claimed in claim 6. A fifth aspect of the invention provides a transceiver as claimed in claim 7. A sixth aspect of the invention provides an integrated circuit as claimed in claim 8. A seventh aspect of the invention provides a telephone device as claimed in claim 9. Advantageous embodiments are defined in the dependent claims.

In an embodiment of the frequency-conversion circuit according to the invention, the frequency divider means comprises a counter means. Such counter means are very simple to integrate. Furthermore, the counter means provide for an exact relation as a function in time, in particular the phase, between the respective oscillator signals intended for each stage of the multistage frequency-converting means. Because of the inherent phase accuracy between the respective oscillator signals derived from both respective outputs of the counter means, a good image or mirror signal suppression is automatically achieved so that, if necessary at all, a modest image rejection-suppression filter will be sufficient in practice to reveal a high-quality frequency conversion. In general, the counter means already have or can easily be provided with outputs for providing both the I and Q oscillator signals to be applied to the I an Q paths respectively, of the multistage frequency-converting means. So separate 90° phase shifters are no longer necessary in the coupling or direct connection between the generally local oscillator and, in particular, the Q paths' oscillator inputs of the multistage frequency-converting means.

These and other aspects and advantages of the present invention will be apparent from and further elucidated with reference to the embodiments and figures described hereinafter. Similar elements in the separate figures are provided with the same reference numerals. In the drawing:

Fig. 1 shows a principle scheme of one embodiment of the frequency-conversion circuit according to the present invention;

Fig. 2 shows an elaborate worked out embodiment of one stage of a multistage frequency-converting means, and a second stage thereof for application in the frequency-conversion circuit of figure 1;

Fig. 3 shows another embodiment of the frequency-conversion circuit according to the invention;

Fig. 4 shows a frequency divider means comprising a series arrangement of counters for application in the frequency-conversion circuit according to the invention;

Fig. 5 shows a frequency divider means comprising a parallel arrangement of counters for application in the frequency-conversion circuit according to the invention;

Fig. 6 shows a frequency divided by 3 means for application in the frequency divider means of figures 4 or 5; and

Fig. 7 schematically shows a telecommunication system comprising transmitters and/or receivers having one or more frequency-conversion circuits according to the invention.

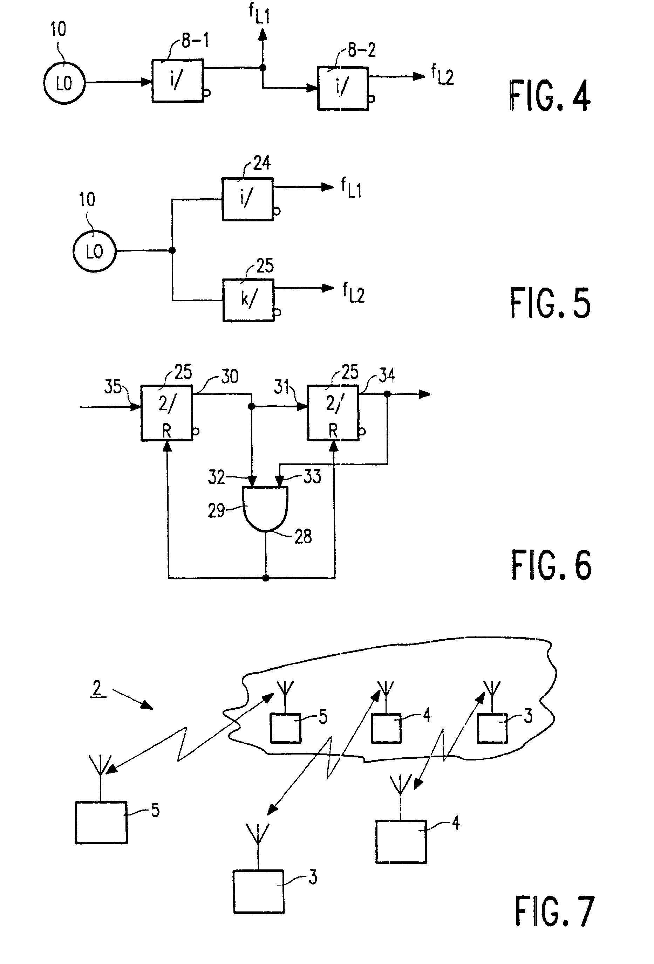

Figure 1 shows a frequency-conversion circuit 1 that can be used in a telecommunication system 2 as schematically shown in figure 7. The telecommunication system 2 shown comprises one or more receivers 3, transmitters 4, and/or transceivers (=transmitter/receiver) 5, each of which contains apart from other circuits, the frequency-conversion circuit 1. The telecommunication system can be a transmission system, such as a radio transmission system, a cordless or cellular telephone system or the like, an audio- or video system, a control system, a telemetry system, a local area network, a wide area network etcetera. Such a frequency-conversion circuit 1 can be used for frequency up conversion or frequency down conversion dependent on the application in a transmitter 4 or receiver 3, respectively.

For the sake of simplification of the description, figures 1-3 relate to frequency-conversion circuits 1 used in a receiver 3, although the frequency-conversion circuits 1 could equally well be used in a transmitter 4 or transceiver 5.

The frequency-conversion circuit 1 comprises an antenna 6 connected to a multistage frequency-converting means 7 showing two conversion stages or mixing stages 7-1 and 7-2 having oscillator inputs referred to in this figure as $f_{L1}$ and $f_{L2}$. The multistage frequency-converting means 7 could include more than two stages although nowadays this is quite uncommon. The antenna signal $f_A$ is mixed in stage 7-1 with a first local oscillator signal $f_{L1}$ and the resulting mixed signal is then mixed in stage 7-2 with a second local oscillator signal $f_{L2}$ to reveal a baseband signal $f_B$ after demodulation (not shown in figures 1 and 2). For zero-IF $f_A = f_{L1} + f_{L2}$.

In figure 2, the stage 7-1 shows in greater detail a quadrature down conversion in an 1-path and a Q-path. The I- and Q paths comprise a mixer 7-1I and 7-1Q, respectively, whereto I and Q local oscillator signals $f_{L1}$ are applied from a frequency divider means 8-1 to be described hereafter. Appropriate 90° phase shifters are provided, as indicated, and the I and Q path signals are subtracted from each other in adder 9 to reveal an intermediate signal to be mixed in stage 7-2 with the second local oscillator signal $f_{L2}$ provided by a frequency divider means 8-2, to be described hereafter, resulting in the baseband signal $f_B$. A local oscillator 10 is coupled to inputs of the multistage frequency converting means 7-1 and 7-2, respectively, as shown in figure 3, that is to say connected through the series arrangement of both frequency divider means 8-1 and 8-2, or as shown in figure 2, connected through the parallel arrangement of both frequency divider means 8-1 and 8-2.

Figure 3 shows a detailed embodiment of how the frequency divider means 8-1, 8-2 are included in only one phase-locked loop 11. The phase-locked loop 11 further comprises the local oscillator in the form of a generally tunable voltage-controlled oscillator 10 having a control input 12 and an oscillator output 13 coupled to the frequency divider means 8-1, which is connected in series to the frequency divider means 8-2 and a further divider 14, which is connected to an input 15 of a phase discriminator 16. The phase discriminator 16 has a reference frequency input for inputting a reference signal $f_{REF}$, such as a signal from a conventional crystal oscillator (not shown) and an output 17 coupled to the control input 12 of the voltage controlled oscillator 10 through a loop filter 18 for a stable control of the PLL. The further divider 14 has a divisor that, in dependence on the divisor of the frequency divider means, matches the local oscillator frequency to the frequency of $f_{REF}$. In the case shown here, the frequency divider means comprises counter means 8-1, 8-2. These counter means easily provide the 1 and Q oscillator signals for both $f_{L1}$ and $f_{L2}$ signals. Embodiments thereof will be presented in figures 4-6.

Figure 3 further shows details of mixing stage 7-2, which is divided in a first pair of branches, which are connected to mixer 7-1I and which comprise mixers 7-2aI and 7-2aQ, which are connected with minus and plus signs to adders 19 and 20, respectively, and in a second pair of branches, connected to mixer 7-1Q and which comprise mixers 7-2bI and 7-2bQ, whixh are connected both with plus signs to the adders 19 and 20, respectively. Quadrature output signals of the adders 19 and 20 are led to a demodulator 21 through bandpass filters 22 and 23, respectively, revealing the actual baseband signal $f_B$. For zero-IF, these filters 22 and 23 can be embodied as low-pass filters.

The operation of the frequency- conversion circuit 1 of figure 3 will now be described for the case wherein the counter means 8-1, 8-2 are simple binary counters which divide the input-signal frequency by 2. Assuming $f_A$=900 MHz, a local oscillator frequency of 1200 MHz, will lead to a value of $f_{L1}$=1200/2=600 MHz. Consequently, $f_{L2}$=600/2=300 MHz and the output signal after the second stage 7-2 will lie in the baseband. Tuning can be achieved by stepping of the local oscillator 10 at 4/3 times the channel spacing steps. Moreover, because in this example the local oscillator frequency does not conincide with the RF-antenna frequency, also crosstalk problems are significantly reduced. In addition, an excellent image suppression is achieved in a way which is easy to integrate on a chip, and which does not require external components or, in the case of zero-IF, filters that are very difficult or impossible integrate, such as polyphase filters, multimixer filters, sequence asymmetric filters and the like.

If, in general, in the series arrangement of counters, the first counter means 8-1 has divisor i and the second counter means 8-2 has divisor j, than the equation for zero-IF is:

$$f_{LO} = f_A.i.j/(j+1)$$

Figure 4 shows a simple way of connecting two 2-counters 8-1 and 8-2 that will generally be included in a phase-locked loop as shown in figure 3. By vurtue thereof, an easily integratable fixed phase relation between the I- and Q-outputs is achieved, which reduces problems that emanate from a varying phase. Figure 5 shows an embodiment of counters 24 and 25 in a possible parallel arrangement Apart from devisors which are equal to 2, also divisors having a different value could be implemented, if necessary. An embodiment of a counter means, such as 8-2, embodied as a 3-counter is shown in figure 6, the 3-counter being built up from easy to integrate 2-counters 26 and 27 having reset inputs R jointly connected to an output 28 of a gate means formed as an AND-port 29. An output 30 of the counter 26, and an input 31 of the counter 27 are jointly connected to a first input 32 of the AND-port 29, whose second input 33 is connected to output 34 of the counter 27 for outputting a signal whose frequency is divided by 3 relative to the signal on input 35 of the counter 26.

**Claims**

1. A frequency-conversion circuit with a multistage frequency converting means comprising:

   a tunable voltage-controlled oscillator (10) having an oscillator output (13) for supplying an oscillator signal,
   a first quadrature mixing stage having an I and a Q path and comprising a first mixer (7-1I) and a second mixer (7-1Q) for receiving a first local oscillator signal ($f_{L1}$), and
   a second quadrature mixing stage having an I and an Q path and comprising a third mixer (7-2aI), a fourth mixer (7-2aQ), a fifth mixer (7-2bI), and a sixth mixer (7-2bQ) for receiving a second local oscillator signal ($f_{L2}$), wherein
   the first mixer (7-1I) has a first input for receiving an I-component of the first local oscillator signal ($f_{L1}$), a second input for receiving an antenna signal ($f_A$), and an output for supplying a first output signal,
   the second mixer (7-1Q) has a first input for receiving a Q-component of the first local oscillator signal ($f_{L1}$), a second input for receiving the antenna signal ($f_A$), and an output for supplying a second output signal,

   the third mixer (7-2aI) has a first input for receiving an I-component of the second local oscillator signal ($f_{L2}$), a second input for receiving the first output signal and an output connected to an inverting input of a first adder (19),
   the fourth mixer (7-2aQ) has a first input for receiving a Q-component of the second local oscillator signal ($f_{L2}$), a second input for receiving the first output signal and an output connected to a non-inverting input of a second adder (20),
   the fifth mixer (7-2bI) has a first input for receiving an I-component of the second local oscillator signal ($f_{L2}$), a second input for receiving the second output signal and an output connected to an non-inverting input of the second adder (20), and
   the sixth mixer (7-2bQ) has a first input for receiving a Q-component of the second local oscillator signal ($f_{L2}$), a second input for receiving the second output signal and an output connected to a non-inverting input of the first adder (19),

   **characterized in that** the multistage frequency converting means further comprises:

   a first frequency divider means (8-1) for receiving the oscillator signal to supply the first local oscillator signal ($f_{L1}$), and
   a second frequency divider means (8-2) for receiving the oscillator signal or the first local oscillator signal ($f_{L1}$) to supply the second local oscillator signal ($f_{L2}$).

2. A frequency-conversion circuit as claimed in claim 1, wherein the second frequency divider means (8-2) is arranged for receiving the first local oscillator signal ($f_{L1}$) and wherein a relation between a frequency $f_{LO}$ of the oscillator signal and a divisor j of the first frequency divider means (8-1) and a divisor i of the second frequency divider means (8-2) is determined by:

   $$f_{LO} = f_A . i . j / (j+1)$$

   wherein $f_A$ is a frequency of an antenna signal supplied to the first quadrature mixing stage.

3. A frequency-conversion circuit as claimed in claim 1, wherein the first frequency divider means (8-1) comprises a first counter and the second frequency divider means (8-2) comprises a second counter.

4. A receiver comprising the frequency-conversion circuit as claimed in claim 1.

5. A transmitter comprising the frequency-conversion circuit as claimed in claim 1.

6. A telecommunications system comprising the frequency-conversion circuit as claimed in claim 1, the telecommunications system being one out of the group: a transmission system, a radio transmission system, a cordless or cellular telephone system, an audio or video system, a control system, a telemetry system, a local area network, or a wide area network.

7. A transceiver comprising the frequency-conversion circuit as claimed in claim 1.

8. An integrated circuit comprising the frequency-conversion circuit as claimed in claim 1.

9. A telephone device comprising the frequency-conversion circuit as claimed in claim 1.

**Patentansprüche**

1. Frequenzumsetzungsschaltung mit einem mehrstufigen Frequenzumsetzungsmittel, das Folgendes umfasst:

einen abstimmbaren spannungsgesteuerten Oszillator (10) mit einem Oszillatorausgang (13), um ein Oszillatorsignal zu liefern, eine erste Quadratur-Mischstufe mit einem I- und einem Q-Pfad und mit einem ersten Mischer (7-1I) und einem zweiten Mischer (7-1Q) zum Empfangen eines ersten lokalen Oszillatorsignals ($f_{L1}$), und eine zweite Quadratur-Mischstufe mit einem I- und einem Q-Pfad und mit einem dritten Mischer (7-2aI), einem vierten Mischer (7-2aQ), einem fünften Mischer (7-2bI) und einem sechsten Mischer (7-2bQ) zum Empfangen eines zweiten lokalen Oszillatorsignals ($f_{L2}$), worin der erste Mischer (7-1I) einen ersten Eingang zum Empfangen einer I-Komponente des ersten lokalen Oszillatorsignals ($f_{L1}$), einen zweiten Eingang zum Empfangen eines Antennensignals ($f_A$) und einen Ausgang zum Liefern eines ersten Ausgangssignals hat, der zweite Mischer (7-1Q) einen ersten Eingang zum Empfangen einer Q-Komponente des ersten lokalen Oszillatorsignals ($f_{L1}$), einen zweiten Eingang zum Empfangen des Antennensignals ($f_A$) und einen Ausgang zum Liefern eines zweiten Ausgangssignals hat, der dritte Mischer (7-2aI) einen ersten Eingang zum Empfangen einer I-Komponente des zweiten lokalen Oszillatorsignals ($f_{L2}$), einen zweiten Eingang zum Empfangen des ersten Ausgangssignals und einen Ausgang hat, der an einen invertierenden Eingang eines ersten Addierers (19) angeschlossen ist, der vierte Mischer (7-2aQ) einen ersten Eingang zum Empfangen einer Q-Komponente des zweiten lokalen Oszillatorsignals ($f_{L2}$), einen zweiten Eingang zum Empfangen des ersten Ausgangssignals und einen Ausgang hat, der an einen nicht-invertierenden Eingang eines zweiten Addierers (20) angeschlossen ist, der fünfte Mischer (7-2bI) einen ersten Eingang zum Empfangen einer I-Komponente des zweiten lokalen Oszillatorsignals ($f_{L2}$), einen zweiten Eingang zum Empfangen des zweiten Ausgangssignals und einen Ausgang hat, der an einen nicht-invertierenden Eingang des zweiten Addierers (20) angeschlossen ist, und der sechste Mischer (7-2bQ) einen ersten Eingang zum Empfangen einer Q-Komponente des zweiten lokalen Oszillatorsignals ($f_{L2}$), einen zweiten Eingang zum Empfangen des zweiten Ausgangssignals und einen Ausgang hat, der an einen nicht-invertierenden Eingang des ersten Addierers (19) angeschlossen ist,

**dadurch gekennzeichnet, dass** das mehrstufigen Frequenzumsetzungsmittel weiter Folgendes umfasst:

ein erstes Frequenzteilermittel (8-1) zum Empfangen des Oszillatorsignals, um das erste lokales Oszillatorsignal ($f_{L1}$) zu liefern, und ein zweites Frequenzteilermittel (8-2) zum Empfangen des Oszillatorsignals oder des ersten lokalen Oszillatorsignals ($f_{L1}$), um das zweite lokale Oszillatorsignal ($f_{L2}$) zu liefern.

2. Frequenzumsetzungsschaltung nach Anspruch 1, in der das zweite Frequenzteilermittel (8-2) angeordnet ist, das erste lokale Oszillatorsignal ($f_{L1}$) zu empfangen und in dem eine Beziehung zwischen einer Frequenz $f_{LO}$ des Oszillatorsignals und einem Teiler j des ersten Frequenzteilermittels (8-1) und einem Teiler i des zweiten Frequenzteilermittels (8-2) bestimmt wird durch:

$$f_{LO} = f_A \cdot i \cdot j / (j+1),$$

worin $f_A$ eine Frequenz eines Antennensignals ist, das an die erste Quadratur-Mischstufe geliefert wird.

3. Frequenzumsetzungsschaltung nach Anspruch 1, in der das erste Frequenzteilermittel (8-1) einen ersten Zähler umfasst und das zweite Frequenzteilermittel (8-2) einen zweiten Zähler umfasst.

4. Empfänger, der die Frequenzumsetzungsschaltung nach Anspruch 1 umfasst.

**5.** Sender, der die Frequenzumsetzungsschaltung nach Anspruch 1 umfasst.

**6.** Telekommunikationssystem, das eine Frequenzumsetzungsschaltung nach Anspruch 1 umfasst, wobei das Telekommunikationssystem eines aus folgender Gruppe ist: ein Übertragungssystem, ein Funkübertragungssystem, ein drahtloses oder Mobiltelefonsystem, ein Audio- oder Videosystem, ein Steuerungssystem, ein Telemetriesystem, ein lokales Netzwerk oder ein Weitverkehrsnetzwerk.

**7.** Transceiver, der die Frequenzumsetzungsschaltung nach Anspruch 1 umfasst.

**8.** Integrierte Schaltung, welche die Frequenzumsetzungsschaltung nach Anspruch 1 umfasst.

**9.** Telefonanordnung, welche die Frequenzumsetzungsschaltung nach Anspruch 1 umfasst.

**Revendications**

**1.** Circuit de conversion de fréquence avec des moyens de conversion de fréquence à plusieurs étages comprenant:

un oscillateur à commande de tension accordable (10) ayant une sortie d'oscillateur (13) pour délivrer un signal d'oscillateur,
un premier étage mélangeur en quadrature ayant un trajet I et un trajet Q et comprenant un premier mélangeur (7-1I) et un deuxième mélangeur (7-1Q) pour recevoir un premier signal d'oscillateur local ($F_{L1}$), et
un deuxième étage mélangeur en quadrature ayant un trajet I et un trajet Q et comprenant un troisième mélangeur (7-2aI), un quatrième mélangeur (7-2aQ), un cinquième mélangeur (7-2bI) et un sixième mélangeur (7-2bQ) pour recevoir un deuxième signal d'oscillateur local ($F_{L2}$) dans lequel
le premier mélangeur (7-1I) présente une première entrée pour recevoir une composante I du premier signal d'oscillateur local ($F_{L1}$), une deuxième entrée pour recevoir un signal d'antenne ($f_A$) et une sortie pour délivrer un premier signal de sortie,
le deuxième mélangeur (7-1Q) présente une première entrée pour recevoir une composante Q du premier signal d'oscillateur local ($F_{L1}$), une deuxième entrée pour recevoir le signal d'antenne ($f_A$) et une sortie pour délivrer un deuxième signal de sortie,
le troisième mélangeur (7-2aI) présente une première entrée pour recevoir une composante I du deuxième signal d'oscillateur local ($F_{L2}$),

une deuxième entrée pour recevoir le premier signal de sortie et une sortie qui est connectée à une entrée inverseuse d'un premier additionneur (19),
le quatrième mélangeur (7-2aQ) présente une première entrée pour recevoir une composante Q du deuxième signal d'oscillateur local ($F_{L2}$), une deuxième entrée pour recevoir le premier signal de sortie et une sortie qui est connectée à une entrée non inverseuse d'un deuxième additionneur (20),
le cinquième mélangeur (7-2bI) présente une première entrée pour recevoir une composante I du deuxième signal d'oscillateur local ($F_{L2}$), une deuxième entrée pour recevoir le deuxième signal de sortie et une sortie qui est connectée à une entrée non inverseuse du deuxième additionneur (20), et
le sixième mélangeur (7-2bQ) présente une première entrée pour recevoir une composante Q du deuxième signal d'oscillateur local ($F_{L2}$), une deuxième entrée pour recevoir le deuxième signal de sortie et une sortie qui est connectée à une entrée non inverseuse du premier additionneur (19),

**caractérisé en ce que** les moyens de conversion de fréquence à plusieurs étages comprennent encore:

des premiers moyens diviseurs de fréquence (8-1) pour recevoir le signal d'oscillateur pour délivrer le premier signal d'oscillateur local ($F_{L1}$), et
des deuxièmes moyens diviseurs de fréquence (8-2) pour recevoir le signal d'oscillateur ou le premier signal d'oscillateur local ($F_{L1}$) pour délivrer le deuxième signal d'oscillateur local ($F_{L2}$).

**2.** Circuit de conversion de fréquence selon la revendication 1, dans lequel les deuxièmes moyens diviseurs de fréquence (8-2) sont agencés de manière à recevoir le premier signal d'oscillateur local ($F_{L1}$) et dans lequel une relation entre une fréquence $f_{LO}$ du signal d'oscillateur et un diviseur j des premiers moyens diviseurs de fréquence (8-1) et un diviseur i des deuxièmes moyens diviseurs de fréquence (8-2) est déterminée par:

$$f_{LO} = f_A \cdot i \cdot j / j+1)$$

) où $f_A$ est une fréquence d'un signal d'antenne qui est délivré au premier étage mélangeur en quadrature.

**3.** Circuit de conversion de fréquence selon la revendication 1, dans lequel les premiers moyens diviseurs de fréquence (8-1) comprennent un premier compteur et les deuxièmes moyens diviseurs de fréquence (8-2) comprennent un deuxième compteur.

4.  Récepteur comprenant le circuit de conversion de fréquence selon la revendication 1.

5.  Emetteur comprenant le circuit de conversion de fréquence selon la revendication 1.

6.  Système de télécommunications comprenant le circuit de conversion de fréquence selon la revendication 1, le système de télécommunications étant un du groupe: un système de transmission, un système de transmission radio, un système téléphonique sans cordon ou cellulaire, un système audio ou vidéo, un système de commande, un système de télémétrie, un réseau local ou un réseau longue distance.

7.  Emetteur-récepteur comprenant le circuit de conversion de fréquence selon la revendication 1.

8.  Circuit intégré comprenant le circuit de conversion de fréquence selon la revendication 1.

9.  Dispositif téléphonique comprenant le circuit de conversion de fréquence selon la revendication 1.

FIG. 1

FIG. 2

FIG. 3

FIG. 4

FIG. 5

FIG. 6

FIG. 7